Europäisches Patentamt

(19) European Patent Office

Office européen des brevets

(11) Publication number: **0 172 915**
**B1**

(12) **EUROPEAN PATENT SPECIFICATION**

(45) Date of publication of patent specification :
11.01.89

(51) Int. Cl.⁴ : **H 05 K 7/14, H 05 K 7/20**

(21) Application number : 85900772.6

(22) Date of filing : 08.02.85

(86) International application number :
PCT/JP 85/00054

(87) International publication number :
WO/8503836 (29.08.85 Gazette 85/19)

(54) **DEVICE FOR MOUNTING POWER CIRCUIT PARTS ON A FLAT MOTHER BOARD.**

(30) Priority : 23.02.84 JP 24830/84 U

(43) Date of publication of application :
05.03.86 Bulletin 86/10

(45) Publication of the grant of the patent :
11.01.89 Bulletin 89/02

(84) Designated contracting states :
DE FR GB

(56) References cited :
DE--A-- 2 608 125
DE--A-- 2 722 142
DE--A-- 2 746 221
JP--A--51 143 869
JP--A--59 225 591
JP--U--58 182 432

(73) Proprietor : FANUC LTD
3580, Shibokusa Aza-Komanba Oshino-mura
Minamitsuru-gun Yamanashi 401-05 (JP)

(72) Inventor : HATTORI, Masayuki
1271-41, Narahara-cho
Hachioji Tokyo 193 (JP)

(74) Representative : Billington, Lawrence Emlyn et al
HASELTINE LAKE & CO Hazlitt House 28 Southampton Buildings Chancery Lane
London WC2A 1AT (GB)

## Description

### Field of the invention

This invention relates to an improvement applicable to an apparatus for mounting electric power circuit parts on a flat mother board. More specifically, this invention relates to an improvement applicable to an apparatus for mounting electric power circuit parts on a flat mother board, the invention being effective to realize various advantages itemized below :

(a) enable electric power circuit parts large in volume and/or weight, e. g. electric power supply units, high-tension circuits, circuits for switching a large amount of electric current, to be directly mounted on a flat mother board,

(b) improve the magnitude of electromagnetic shield for printed boards employable for control circuits (herein-after referred to as a control card),

(c) improve the magnitude of isolation for and/or confinement of high-tension parts, thereby improving the safety, and

(d) enable electric parts e. g. a power supply unit to be made smaller in dimension and/or to be standardized.

### Background of the invention

A control unit in which plural printed boards are assembled, is widely employed. The control units available in the prior art have plural racks on which printed boards are mounted. On the other hand, it is usual in the prior art that electric power circuit parts large in volume and/or weight, e. g. electric power supply units, high-tension circuits, circuits for switching a large amount of electric current, are not mounted on a printed board but placed on the bottom plate of a control unit. This is because it is not necessarily easy for a printed board to bear high-tension power circuit parts large in volume and/or weight, and moreover, it is not generally understood that a printed board must bear large and/or heavy parts. Accordingly, each rack bear control cards alone, each of which is detachably inserted from the operation front of the control unit, in the manner in which the control cards vertically stand on their sides to be parallel with one another and also in the manner in which plug terminals arranged at the rear side of the control cards are connected with the corresponding plug terminals which are arranged along the rear panel of the control unit.

Thus, the quantity of the power supplies and/or power circuits et al. mounted on a single control unit is usually limited to one or some marginal number. If each circuit is allowed to have its own power supply and/or power circuit, or if power supplies and/or power circuits are allowed to be mounted on an arbitrary rack, it is clearly convenient at least in some specific cases.

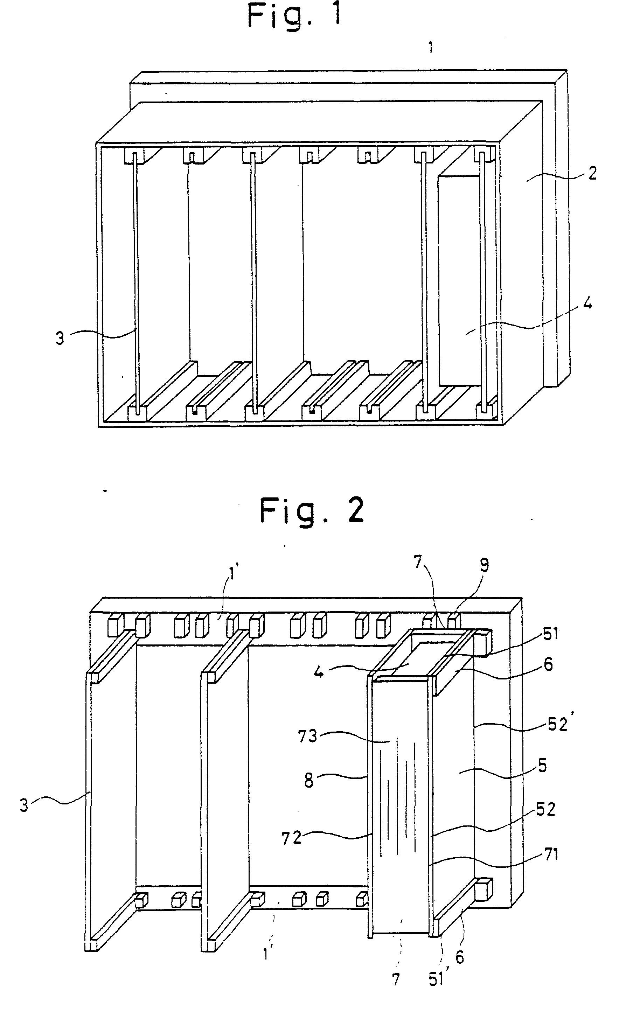

Under such technical environments, a control unit having box type racks, as shown in Fig. 1, was developed. Referring to the drawing, each rack of the control unit consists of a mother board (1) which bears the aforementioned box type support means (2), which further bear control cards (3) which are connected with the wirings of the mother board (1) by means of plug type connectors (not shown) arranged at the rear side of the mother board (1). Electric power circuit parts (4) e. g. an electric power supply are mounted at an arbitrary location of the aforementioned box type support means (2) which constitute each rack. The connection between the power circuit parts (4) and the mother board (1) is implemented, in the similar manner as in the case of the connection between the control cards (3) and the mother board (1), by means of plug type connectors (not shown) arranged at the rear side of the mother board (1).

However, the aforementioned system in which each control card (3) and/or each power circuit part (4) is or are mounted on a mother board (1) by means of the aforementioned box type support means (2), is involved with various items of inconvenience in the aspects of fabrication, operation, maintenance et al. Further, the system is involved with a drawback also in the aspect of transportation, because the volume/dimension of the box type support means (2) is inclined to be relatively large. As a result, the aforementioned system is understood to be somewhat unsatisfactory.

### Object and disclosure of the invention

The object of this invention is to provide an apparatus for mounting electric power circuit parts on a flat mother board, which realizes the various advantages itemized below :

(a) The electric power circuit parts can be mounted rigidly without possibilities in which the parts are unintentionally dislocated, whereby the safety is enhanced,

(b) The high-tension parts are not exposed, whereby the safety is enhanced,

(c) The heat radiation capacity is adjustable, resultantly effective to minimize the dimension of and to standardize the model of the power supply unit et al.,

(d) Fabrication, operation, maintenance et al., are easy, and

(e) No possibilities to cause electromagnetic disturbance relative to the other control cards mounted on a control unit.

To achieve the aforementioned object, an apparatus for mounting electric power circuit parts on a flat mother board in accordance with this invention comprises :

(a) a rectangular plate provided with at least one electric power circuit part mounted on one surface of the rectangular plate,

(b) a pair of rod means arranged on the other surface of the rectangular plate along the upper and lower horizontal edges of the rectangular plate,

(c) a pair of rectangular heat sinks extending perpendicularly to the rectangular plate in a direction to cover the at least one electric power circuit part, each of the heat sinks being respectively fixed to the rectangular plate along the corresponding one of the vertical sides of the rectangular plate,

(d) a rectangular electromagnetic shielding plate which is fixed perpendicularly to the rectangular heat sinks along the respective vertical sides of the rectangular heat sinks so as to face the rectangular plate, the rectangular electromagnetic shielding plate being arranged with the rectangular plate and the pair of rectangular heat sinks so as to form a rectangular tube,

(e) whereby the apparatus for mounting electric power circuit parts on a flat mother board, is mounted on a flat mother board by means of one of the aforementioned pair of rectangular heat sinks and the pair of rod means.

Brief description of the drawing

A more detailed description will be presented below for an apparatus for mounting electric power circuit parts on a flat mother board in accordance with an embodiment of this invention, referring to drawings tabulated below :

Fig. 1 is a schematic drawing of an apparatus for mounting electric power circuit parts on a flat mother board available in the prior art,

Fig. 2 is a right-side perspective view of an apparatus for mounting electric power circuit parts on a flat mother board in accordance with an embodiment of this invention, and

Fig. 3 is a left-side perspective view of an apparatus for mounting electric power circuit parts on a flat mother board in accordance with an embodiment of this invention.

Detailed description of preferred embodiment

Referring to the drawings, a more detailed description will be presented below for an apparatus for mounting electric power circuit parts on a flat mother board in accordance with an embodiment of this invention.

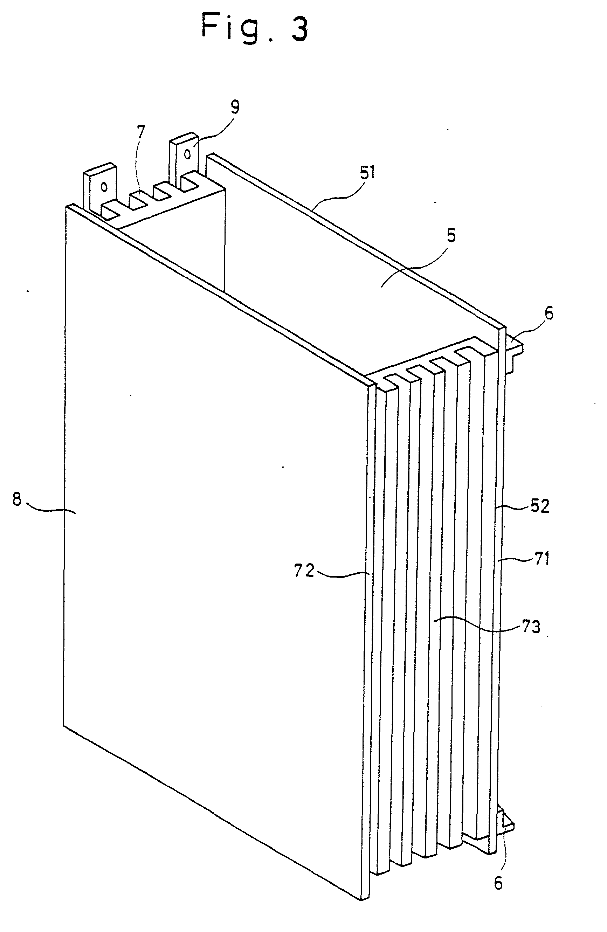

Referring to Figs. 2 and 3, a flat mother (1') is mounted on a control unit (not shown) and functions as a rack. Each rack supports plural control cards (3) (Only two cards are shown in Fig. 2.) and a rectangular plate (5) which further supports an electric power circuit part (4). Each rack further causes the control cards (3) and the electric power circuit part (4) to be connected with wirings (not shown) arranged at the rear side of the mother board (1').

The electric power circuit part (4) is mounted on one surface (the left surface in Figs. 2 and 3) of the rectangular plate (5). As a result, supporting rods of the electric power circuit part (4) penetrate toward the other surface (the right surface in Figs. 2 and 3) of the rectangular plate (5), and are fixed hereto by means of soldering et al.

In the case where electromagnetic shielding is required, for example in the case where the apparatus for mounting electric power circuit parts on a flat mother board, is placed between control cards, the rectangular plate (5) is preferably shielded directly or indirectly.

The rod means (6) are arranged along the upper and lower horizontal edges (51) and (51') of the rectangular plate (5). The rod means (6) are arranged on a surface of the rectangular plate (5), on which surface the electric power circuit part (4) is not mounted (or on the right surface in Figs. 2 and 3). The rod means (6) has a function to fix the apparatus for mounting electric power circuit parts on a flat mother board, to the mother board (1').

One side (71) of each of the rectangular heat sinks (7) is respectively fixed to each of the parallel vertical sides (52) and (52') of the rectangular plate (5), and each of the rectangular heat sinks (7) extends in the direction to cover the electric power circuit part (4) (in the leftward direction in Figs. 2 and 3). Fins (73) can be arranged in the vertical direction, if required.

The rectangular shielding plate (8) is fixed to the pair of rectangular heat sinks (7) to face the rectangular plate (5). Namely, the rectangular shielding plate (8) is fixed to the other side (72) of the rectangular heat sink (7) which side (72) faces the aforementioned side (71) of the rectangular heat sink. As a result, a combination of the rectangular plate (5), the pair of rectangular heat sinks (7) and the rectangular electromagnetic shielding plate (8) produces a rectangular tube (a tube having a rectangular cross-section) or a rectangular solid penetrated by a hollow rectangular space, which rectangular tube is allowed to function as a mechanically strong container to contain the electric power circuit parts (4).

The electric power circuit part (4) is housed in the rectangular hollow space of the aforementioned rectangular tube container. An equipment for fixing the rectangular tube container which constitutes the apparatus for mounting electric power circuit parts on a flat mother board, is one of the rectangular heat sinks (7) (the rear-side-one of the heat sinks (7)), a tab (9) fixed to the rear-side-one of the heat sinks (7), the rod means (6) or a combination of these members.

The features specific to the apparatus for mounting electric power circuit parts on a flat mother board having the aforementioned mechanical structure are itemized below :

(a) Since a combination of members which are not inherently structural members (namely, a combination of a rectangular plate (5), a pair of heat sinks (7) and a rectangular electromagnetic shielding plate (8)) successfully produces a rectangular tube containers which is strong sufficient to support the electric power circuit part (4), it is allowed to mount the electric power circuit part (4) on a flat mother board (1') with a sufficiently reliable degree of the mechanical strength, resultantly preventing the rectangular plate (5) from being buckled. Further, since no independent structural means are required, it is allowed to decrease the dimension and weight of the apparatus for mounting electric power circuit parts on a flat mother board.

(b) Since the aforementioned rectangular tube container covers the high-tension parts, it enhances the grade of safety.

(c) Since an inherent electromagnetic shielding plate (8) is employed, the grade of electromagnetic shielding effects is enhanced in the direction in which the inherent shielding plate is available. In addition, in the case where an additional electromagnetic shielding means is attached to the rectangular plate (5), the electromagnetic shielding effects are satisfactory in all directions,

(d) It is readily possible to adjust the capacity of the aforementioned rectangular tube container by varying the dimension of the heat sinks (7), and

(e) It is possible to enhance the heat radiation effects by adding fins (73) to the rectangular electromagnetic shielding plate (8).

In conclusion, the very important feature of this invention can be understood to be the creation of an entirely new or additional functional member by a combination of various members (a rectangular plate of a material identical to that of a printed board, a heat sink and a shielding plate) each of which has various other inherent functions, and an increase of the realistic value by increasing the versatility/flexibility.

The foregoing description has clarified that this invention successfully provided an apparatus for mounting electric power circuit parts on a flat mother board, which realizes the various advantages itemized below :

(a) The electric power circuit parts can be mounted rigidly without possibilities in which the parts are unintentionally dislocated, whereby the safety is enhanced,

(b) The high tension parts are not exposed, whereby the safety is enhanced,

(c) The heat radiation capacity is adjustable, resultantly effective to minimize the dimension of and to standardize the model of the power supply et al.,

(d) Fabrication, operation, maintenance et al., are easy, and

(e) No possibilities to cause electromagnetic disturbance relative to the other control cards mounted on a control unit.

Although the foregoing description was presented referring to a specific embodiment, this is not meant to be construed in a limiting sense.

## Claim

An apparatus for mounting electric power circuit parts on a flat mother board comprising :
a rectangular plate (5) provided with at least one electric power circuit part (4) mounted on one surface of the rectangular plate, a pair of rod means (6) arranged on the other surface of said rectangular plate (5) along the upper and lower horizontal edges (51) and (51') of said rectangular plate (5),
a pair of rectangular heat sinks (7) extending perpendicularly to the rectangular plate in a direction to cover said at least one electric power circuit part (4) each of the heat sinks being respectively fixed to the rectangular plate along the corresponding one of the vertical sides (52, 52') of said rectangular plate (5),
a rectangular electromagnetic shielding plate (8) which is fixed perpendicularly to the rectangular heat sinks (7) along the respective vertical sides of said rectangular heat sinks (7) so as to face the rectangular plate, said rectangular electromagnetic shielding plate (8) being arranged with said rectangular plate (5) and said pair of rectangular heat sinks (7) so as to form a rectangular tube,
whereby said apparatus for mounting electric power circuit parts on a flat mother board, is mounted on a flat mother board (1') by means of one of said pair of rectangular heat sinks (7) and said pair of rod means (6).

## Patentanspruch

Vorrichtung zur Montierung von Leistungsstromkreiteilen auf ein flaches Mutterbrett, mit
einer rechteckigen Platte (5), die mit zumindest einem Leistungsstromkreisteil (4) versehen ist, das auf eine Oberfläche der rechteckigen Platte montiert ist,
einem Paar von Stangenelementen (6), die auf der anderen Oberfläche der rechteckigen Platte (5) längs der oberen und unteren horizontalen Kanten (51) und (51') der rechteckigen Platte (5) angeordnet sind,
einem Paar von rechteckigen Wärmesenken (7), die sich senkrecht zu der rechteckigen Platte in einer Richtung erstrecken, um zumindest ein Leistungsstromkreisteil (4) abzudecken, wobei jede der Wärmesenken an der rechteckigen Platte längs der korrespondierenden der vertikalen Seiten der rechteckigen Platte (5) befestigt ist, und
einer rechteckigen elektromagnetischen Abschirmplatte (8), die senkrecht zu den rechteckigen Wärmesenken (7) längs der jeweiligen vertikalen Seiten der rechteckigen Wärmesenken an diesen befestigt ist, um der rechteckigen Platte gegenüberzuliegen, welche rechteckige elektromagnetische Abschirmplatte (8) derart zusammen mit der rechteckigen Platte (5) und dem Paar von rechteckigen Wärmesenken (7) angeordnet ist, daß ein Rohr mit rechteckigem Querschnitt gebildet ist, durch welches die Vorrichtung zur Montierung von Leistungsstromkreisteilen auf ein flaches Mutterbrett mittels einer des Paares von rechteckigen Wärmesenken (7) und des Paares von Stangenelementen (6) auf ein flaches Mutterbrett (1') montiert wird.

## Revendication

Un appareil pour monter des pièces de circuit de puissance électrique sur un panneau mère plat comprenant :

une plaque rectangulaire (5) munie d'au moins une pièce de circuit de puissance électrique (4) montée sur une surface de la plaque rectangulaire, une paire de tiges (6) disposée sur l'autre surface de ladite plaque rectangulaire (5) le long des bords horizontaux supérieur et inférieur (51) et (51') de ladite plaque rectangulaire (5),

une paire de dissipateurs de chaleur rectangulaire (7) s'étendant perpendiculairement à la plaque rectangulaire dans un sens permettant de recouvrir au moins une desdites pièces de circuit de puissance électrique (4), chacun des dissipateurs étant respectivement fixé à la plaque rectangulaire le long du côté correspondant des côtés verticaux (52), (52') de ladite plaque rectangulaire (5),

une plaque de blindage électromagnétique rectangulaire (8) qui est fixée perpendiculairement aux dissipateurs de chaleur rectangulaires (7) le long des côtés verticaux respectifs desdits dissipateurs de chaleur rectangulaires (7) de manière à faire face à la plaque rectangulaire, ladite plaque de blindage électromagnétique rectangulaire (8) étant disposée avec ladite plaque rectangulaire (5) et ladite paire de dissipateurs de chaleur rectangulaires (7) de manière à former un tube rectangulaire,

ce qui fait que ledit appareil pour monter des pièces de circuit de puissance électrique sur un panneau mère plat est monté sur un panneau mère plat (1') au moyen d'un parmi ladite paire de dissipateurs de chaleur rectangulaires (7) et ladite paire de tiges (6).

EP 0 172 915 B1

# Fig. 1

# Fig. 2

# Fig. 3